# EUROPEAN PATENT APPLICATION

(11) **EP 2 001 055 A2**
(43) Date of publication of application: **10.12.2008**
(21) Application number: 08157587.0
(22) Date of filing: 04.06.2008
(51) Int. Cl.: H01L 27/32

(54) **Organic light emitting display device and mother substrate thereof**

(30) Priority: 05.06.2007 KR 20070054900
(71) Applicant: Samsung SDI Co., Ltd., Suwon-si, Gyeonggi-do (KR)
(72) Inventor: Oh, Back-Koun, Samsung SDI Co., Ltd., Suwon-si, Gyeonggi-do (KR)
(74) Representative: Bonnans, Arnaud

(57) **Abstract**

An organic light emitting display device (610) capable of being inspected in a mother substrate unit (600), and a mother substrate (600) of an organic light emitting display device including a plurality of organic light emitting display devices (610) including data lines (D) and scan lines (S); and scribing lines (601) arranged between the organic light emitting display devices in a row direction or a column direction and partitioning regions of the organic light emitting display devices, wherein the data lines (D) of the organic light emitting display device (610) formed inside a region defined by first to fourth scribing lines are electrically coupled with a first pin-contact unit (660) formed outside the first scribing line, and the scan lines (S) of the organic light emitting display device formed inside a region defined by the first to fourth scribing lines are electrically coupled with a second pin-contact unit formed outside the second or third scribing lines, which are orthogonal to the first scribing line and parallel with each other.

## Description

The invention relates to an organic light emitting display device and a mother substrate comprising the same, and more particularly to an organic light emitting display device capable of being inspected in a mother substrate unit, and a mother substrate comprising the same.

Among flat panel display technologies, an organic light emitting display device includes a pixel unit having a plurality of pixels, which are arranged at crossing points of scan lines and data lines. Each of the pixels includes at least an organic light emitting diode. A pixel is selected by a scan signal supplied by the scan line, and emits the light with a luminance corresponding to the value of a data signal supplied by the data line.

However, the luminance of a pixel is sensitive to a voltage level of the scan signal and/or data signal of the organic light emitting display device, and therefore, the scan lines and/or the data lines are manufactured using selected materials having a low resistance.

A plurality of organic light emitting display devices is typically formed on one mother substrate and are separated from each other by scribing and dicing the mother substrate. The inspection of the organic light emitting display devices is then carried out separately on the scribed and diced organic light emitting display devices.

However, if the inspection is carried out separately on the organic light emitting display devices as described above, inspection efficiency may be lowered.

Accordingly, some embodiments solve such drawbacks, and therefore an object is to provide an organic light emitting display device capable of reducing resistance of scan lines and/or data lines by employing materials having a low resistance, and a mother substrate thereof.

Also, another object is to provide an organic light emitting display device capable of improving inspection efficiency by carrying out an inspection on the organic light emitting display devices in a unit of mother substrate, and a mother substrate thereof.

In this context, the invention proposes a mother substrate of an organic light emitting display device including a plurality of organic light emitting display devices including data lines and scan lines; and scribing lines arranged between the organic light emitting display devices in a row direction or a column direction and partitioning regions of the organic light emitting display devices, wherein the data lines of the organic light emitting display device formed inside a region defined by first to fourth scribing lines out of the scribing lines are electrically coupled with a first pin-contact unit formed outside the first scribing line, and the scan lines of the organic light emitting display device formed inside a region defined by the first to fourth scribing lines are electrically coupled with a second pin-contact unit formed outside the second or third scribing line, which is orthogonal to the first scribing line and parallel with each other.

Preferably, the first pin-contact unit may be formed in a lower (dummy) region of adjacent organic light emitting display devices arranged in the prior column to share the first scribing line, and the second pin-contact unit may be formed on a left or right (dummy) region of adjacent organic light emitting display devices arranged in the prior column or the next column to share the second or third scribing line. The first and second pin-contact units may be electrically isolated from the data lines and the scan lines of the adjacent organic light emitting display devices in which the first and second pin-contact units themselves are arranged. Each of the organic light emitting display devices may include a pixel unit having a plurality of pixels arranged in crossing points of the data lines and the scan lines and including at least an organic light emitting diode; a drive circuit unit electrically coupled to the data lines and scan lines to supply a driving signal to the pixel unit; and a pad unit electrically coupled to the drive circuit unit to supply a power source voltage or a control signal to the drive circuit unit. One region of the scan lines or data lines arranged inside the pixel unit may be formed of a first conductive layer composed of the same materials as a first electrode or a second electrode of the organic light emitting diode, and the other region of the scan lines or data lines arranged between the pixel unit and the drive circuit unit may be formed in a laminated structure of the first conductive layer and the second conductive layer composed of different materials from the first conductive layer. The second conductive layer may be formed of a material having a lower resistance than the first conductive layer. The second conductive layer may be formed of one of molybdenum (Mo) and aluminum (Al). The second conductive layer may be formed in a triple-layer structure of molybdenum (Mo)-aluminum (Al)-molybdenum (Mo). The first or second pin-contact unit may be formed of one of materials constituting the second conductive layer. The second conductive layer may include at least aluminum (Al), and the first or second pin-contact unit is formed of the aluminum (Al). The first conductive layer may include at least an indium tin oxide (ITO) film. The first pin-contact unit may be formed respectively in (dummy) regions of both sides of the pad unit in the adjacent organic light emitting display devices arranged in the prior column. The second pin-contact unit may be formed in one (dummy) region of the drive circuit unit installed in the adjacent organic light emitting display devices arranged in the prior column or the next column. The drive circuit unit may be installed in a form of an integrated circuit chip. The first and second pin-contact units may receive an inspection_data signal and an inspection_scan signal, respectively.

The invention therefore also provides an organic light emitting display device including a pixel unit having a plurality of pixels arranged in crossing points of scan lines and data lines and including at least an organic light emitting diode; and first and second pin-contact units arranged in a lower (dummy) region of the pixel unit (e.g. a region not used for operation of the concerned display device) and electrically isolated from the scan lines and the data lines, wherein the data lines are extended toward an upper (dummy) region of the pixel unit and their extended terminals are floated (or stand free), and the scan lines are extended toward edges of both sides of a lower (dummy) region of the pixel unit and their extended terminals are floated.

Preferably, the organic light emitting display device may further include a drive circuit unit arranged in one side of the pixel unit and electrically coupled with the pixel unit; and a pad unit electrically coupled to the drive circuit unit to supply a power source voltage or a control signal to the drive circuit unit. The first pin-contact unit may be formed in (dummy) regions of both sides of the pad unit, respectively. The second pin-contact unit may be formed in a (dummy) region of at least one side of the drive circuit unit. The second pin-contact unit may be formed in (dummy) regions of both sides of the drive circuit unit one by one, respectively. One region of the scan lines or data lines arranged inside the pixel unit may be composed of first conductive layers made of the same materials as the first electrode or the second electrode of the organic light emitting diode, and the other region of the scan lines or data lines extended outwardly to the pixel unit may be formed in a laminated structure of the first conductive layer and the second conductive layer composed of different materials from the first conductive layer. The first or second pin-contact unit may be formed of at least one of materials constituting the second conductive layer. The first or second pin-contact unit and the second conductive layer may include at least aluminum (Al). The second conductive layer may be formed of materials having a lower resistance than the first conductive layer. The second conductive layer may be formed in a laminated structure of molybdenum (Mo)-aluminum (Al)-molybdenum (Mo). The first conductive layer may include at least an indium tin oxide (ITO) film.

Some embodiments provide a mother substrate of an organic light emitting display device comprising: a plurality of organic light emitting display devices comprising data lines and scan lines disposed on a substrate; and scribing lines arranged horizontally and vertically between adjacent organic light emitting display devices, the scribing lines partitioning the substrate into rows and columns of regions, each region comprising an organic light emitting display device. The data lines of an organic light emitting display device formed inside a region defined by first, second, third, and fourth scribing lines extend out of the region and are electrically coupled with a first pin-contact unit formed outside the first scribing line, and the scan lines of the organic light emitting display device formed inside the region defined by the first, second, third, and fourth scribing lines extend out of the region and are electrically coupled with a second pin-contact unit formed outside the second or third scribing line, which are orthogonal to the first scribing line and parallel with each other.

In some embodiments, the first pin-contact unit is formed in a lower dummy region of an adjacent organic light emitting display device in an adjacent row sharing the first scribing line, and the second pin-contact unit is formed in a left or right dummy region of an adjacent organic light emitting display device in an adjacent column sharing the second or third scribing line. In some embodiments, the first and second pin-contact units are electrically isolated from the data lines and the scan lines of the adjacent organic light emitting display devices in which the first and second pin-contact units are disposed.

In some embodiments, each of the organic light emitting display devices comprises: a pixel unit comprising a plurality of pixels arranged at crossing points of the data lines and the scan lines, each pixel comprising at least an organic light emitting diode; a drive circuit unit electrically coupled to the data lines and scan lines configured to supply a driving signal to the pixel unit; and a pad unit electrically coupled to the drive circuit unit configured to supply at least one of a power source voltage and a control signal to the drive circuit unit.

In some embodiments, one of the scan lines or data lines disposed inside the pixel unit comprises a first conductive layer comprising the same material as a first electrode or a second electrode of the organic light emitting diode, and the other of the scan lines or data lines disposed between the pixel unit and the drive circuit unit comprises a laminated structure comprising the first conductive layer and a second conductive layer comprising a different material than the first conductive layer.

In some embodiments, the second conductive layer comprises a material having a lower resistance than the first conductive layer. In some embodiments, the second conductive layer comprises one of molybdenum (Mo) and aluminum (Al). In some embodiments, the second conductive layer comprises a triple-layer structure of molybdenum (Mo)-aluminum (Al)-molybdenum (Mo).

In some embodiments, the first or second pin-contact unit comprises a material of the second conductive layer. In some embodiments, the second conductive layer comprises at least aluminum (Al), and the first or second pin-contact unit comprises aluminum (Al).

In some embodiments, the first conductive layer comprises at least an indium tin oxide (ITO) film.

In some embodiments, the first pin-contact unit is formed in dummy regions on either side of a pad unit of an adjacent organic light emitting display device in an adjacent row sharing the first scribing line. In some embodiments, the second pin-contact unit is formed in at least one of a dummy region of a drive circuit unit installed in an adjacent organic light emitting display device in an adjacent column sharing the second scribing line and a dummy region of a drive circuit unit installed in an adjacent organic light emitting display device sharing the third scribing line. In some embodiments, the drive circuit unit is installed in a form of an integrated circuit chip.

In some embodiments, the first and second pin-contact units are configured to receive an inspection_data signal and an inspection_scan signal, respectively.

Some embodiments provide an organic light emitting display device, comprising: a pixel unit comprising a plurality of pixels arranged at crossing points of scan lines and data lines, each pixel comprising at least an organic light emitting diode; and first and second pin-contact units disposed in a lower dummy region of the pixel unit and electrically isolated from the scan lines and the data lines, the data lines extend toward an upper dummy region of the pixel unit and the extended terminals are floated, and the scan lines extend toward edges of both sides of a lower dummy region of the pixel unit and the extended terminals are floated.

Some embodiments further comprise: a drive circuit unit disposed on one side of the pixel unit and electrically coupled with the pixel unit; and a pad unit electrically coupled to the drive circuit unit configured to supply at least one of a power source voltage and a control signal to the drive circuit unit.

In some embodiments, the first pin-contact unit is formed in dummy region on both sides of the pad unit. In some embodiments, the second pin-contact unit is formed in a dummy region on at least one side of the drive circuit unit. In some embodiments, the second pin-contact unit is formed in dummy region on both sides of the drive circuit unit.

In some embodiments, one of the scan lines or data lines arranged inside the pixel unit comprises a first conductive layer comprising the same material as the first electrode or the second electrode of the organic light emitting diode, and the other of the scan lines or data lines extending outwardly to the pixel unit comprises a laminated structure comprising the first conductive layer and a second conductive layer comprising a different material than the first conductive layer.

In some embodiments, the first or second pin-contact unit comprises at least one material of the second conductive layer. In some embodiments, the first or second pin-contact unit and the second conductive layer comprises at least aluminum (Al).

In some embodiments, the second conductive layer comprises a material having a lower resistance than the first conductive layer. In some embodiments, the second conductive layer comprises a laminated structure of molybdenum (Mo)-aluminum (Al)-molybdenum (Mo). In some embodiments, the first conductive layer comprises at least an indium tin oxide (ITO) film.

These and/or other aspects and advantages will become apparent and more readily appreciated from the following description, taken in conjunction with the accompanying drawings of which:
FIG. 1 is a top view showing a schematic configuration of an organic light emitting display device.
FIG. 2 is a cross-sectional view taken through section line I-I' of the organic light emitting display device as shown in FIG. 1.
FIG. 3 is a cross-sectional view showing one embodiment of the scan lines and/or data lines shown in FIG. 1 and FIG. 2.
FIG. 4 and FIG. 5 are top views showing a mother substrate of an organic light emitting display device.
FIG. 6 is a top view showing a mother substrate of an organic light emitting display device according to an embodiment of the present invention.
FIG. 7 is a detail view showing data lines and a first pin-contact unit shown in FIG. 6.
FIG. 8 is a detail view showing scan lines and a second pin-contact unit shown in FIG. 6.
FIG. 9 is a top view showing one embodiment of the organic light emitting display device that is scribed along a scribing line shown in FIG. 6.

Hereinafter, exemplary embodiments will be described with reference to the accompanying drawings. It should be understood that, when one element is coupled to another element, one element may be in practice not necessarily directly coupled to another element but as a variation indirectly coupled to another element via a third element. Further, elements not described because they do not relate to operation of the invention are omitted for clarity. Also, like reference numerals refer to like elements throughout.

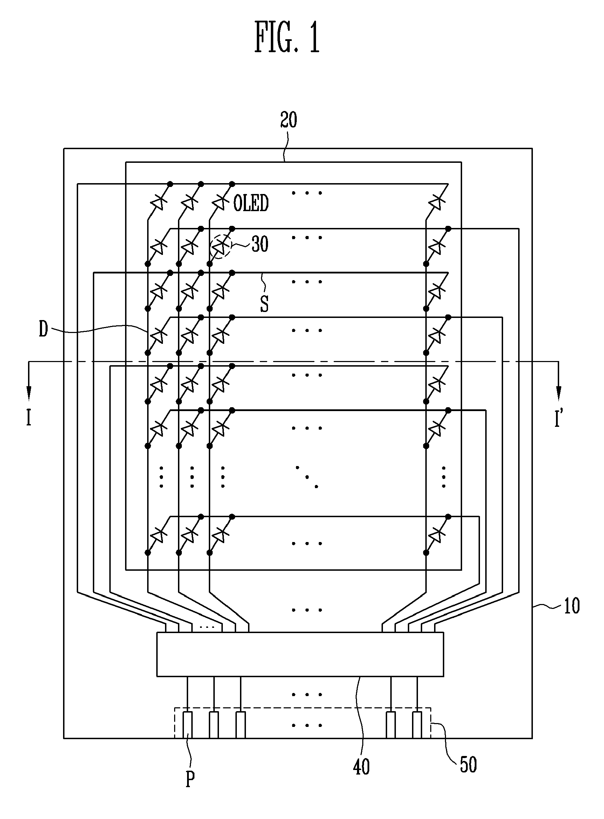

FIG. 1 is a top view showing a schematic configuration of an organic light emitting display device. For the sake of convenience, a passive organic light emitting display device is shown in FIG. 1, but other embodiments are not particularly limited thereto.

Referring to FIG. 1, the organic light emitting display device includes a pixel unit 20 formed on a substrate 10; a drive circuit unit 40 for supplying a driving signal to the pixel unit 20; and a pad unit 50 for supplying a power source voltage and control signals to the drive circuit unit 40.

The pixel unit 20 comprises crossing points of scan lines (S) and data lines (D), and includes a plurality of pixels 30 including at least an organic light emitting diode (OLED). Each of the pixels 30 is selected by a scan signal supplied from the scan line (S) to generate the light having a luminance corresponding to a data signal supplied from the data lines (D), thereby displaying an image in the pixel unit 20.

The drive circuit unit 40 is arranged in one side of the pixel unit 20, and electrically coupled with the pixel unit 20 through the scan lines (S) and the data lines (D). Such a drive circuit unit 40 generates a driving signal to correspond to the power source voltage and the control signals supplied from the pad unit 50, and supplies the generated driving signal to the pixel unit 20. For example, the drive circuit unit 40 may generate a scan signal and a data signal, and supply the generated scan signal and data signal to the scan lines (S) and the data lines (D), respectively.

Such a drive circuit unit 40 may be formed on a panel, or installed on a substrate in a form of an integrated circuit (IC) chip, or installed in a printed circuit board (not shown), and then electrically coupled with the pixel unit 20. If the drive circuit unit 40 is installed on a panel in a form of an integrated circuit chip as shown in FIG. 1, the number of the pads (P) may be reduced, and therefore it is possible to reduce the manufacturing cost required for the formation of the conductive film that is used for forming the pad unit 50.

The pad unit 50 comprises a plurality of pads (P) arranged on an edge of one side of the organic light emitting display device, and supplies an external power source voltage and/or control signals to the inside of the panel through the pads (P). In particular, the pad unit 50 is electrically coupled to the drive circuit unit 40 to supply the power source voltage and/or the control signals to the drive circuit unit 40. Meanwhile, although not shown in FIG. 1 for the sake of convenience, the pad unit 50 may further include a pad electrically coupled with the pixel unit 20, which supplies an external power source to the pixel unit 20 through the pad.

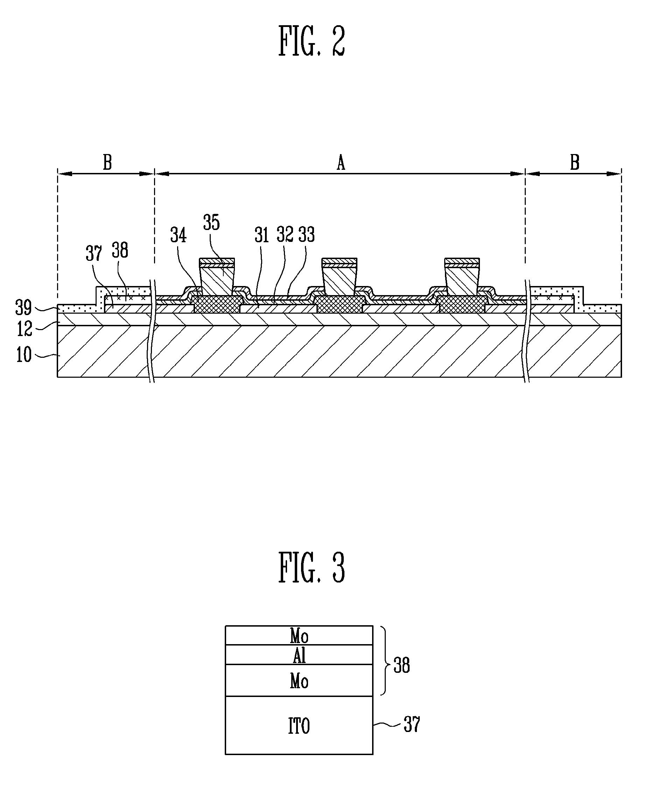

FIG. 2 is a cross-sectional view taken through section line I-I' of the organic light emitting display device as shown in FIG. 1. In FIG. 2, Region A represents a region of the pixel unit 20, and Region B represents a region of a wiring region outside the pixel unit 20. Hereinafter, cross-sectional structures of the pixel unit 20 and the wiring region will be described in more detail with reference to FIG. 2 in connection with FIG. 1.

First, transparent materials may be used in the substrate 10, for example, glass and plastic materials such as acryl, polyimide, polycarbonate, polyester, and the like. Also, a metal foil such as SUS, tungsten and the like may be used in the substrate. A buffer layer 12 is formed on such a substrate 10.

First electrodes 31 of the organic light emitting diode is formed on the buffer layer 12 in the pixel region (A), the first electrodes 31 being patterned in a predetermined pattern. For example, the first electrodes 31 may be formed by patterning indium tin oxide (hereinafter, referred to as ITO) as a transparent electrode material in a stripe. In this embodiment, data lines (D) are formed together with the first electrodes 31. Here, the first electrode materials are not limited to ITO. In other embodiments, the first electrode 31 may be formed of transparent electrode materials such as IZO, ZnO, In₂O₃, or the like, for example, in embodiments where the OLED device is configured for the bottom light emission. Also, the first electrode 31 may also be formed of reflective electrode materials such as Ag, Mg, Al, Cr, or the like, for example, in embodiments where the OLED device is configured for the top light emission. As noted above, the embodiment described here uses a first electrode 31 formed of ITO.

An interlayer insulator 34 is formed between adjacent first electrodes 31, and a separated insulator 35 is formed on the interlayer insulator 34. The separated insulator 35 is for the purpose of patterning the light emitting layer 32 and the second electrode 33.

For the sake of convenience, FIG. 2 shows the separated insulator 35 and the first electrodes 31 arranged in parallel with each other, but the separated insulator 35 and the first electrodes 31 are actually arranged orthogonally to each other.

Accordingly, if the light emitting layer 32 and the second electrode 33 are formed after the separated insulator 35 is already formed, the light emitting layer 32 and the second electrode 33 may be formed in a pattern in which they are arranged orthogonally to the first electrode 31. However, the present embodiment is not particularly limited to the patterning method of the light emitting layer 32 and the second electrode 33, and the light emitting layer 32 and the second electrode 33 may be patterned in a deposition process using a patterning mask.

Here, the light emitting layer 32 may comprise a low molecular weight organic layer or a high molecular weight organic layer.

Further, the second electrode 33 may comprise a reflective electrode material or a transparent electrode material. For example, if used for a bottom-light-emission device, the first electrode 31 may be formed of a transparent electrode material such as ITO, and the second electrode 33 may be formed of a reflective electrode material such as aluminum (Al). Such a second electrode 33 may be formed by patterning the reflective electrode material in a stripe in a direction orthogonal to the first electrode 31. In this case, scan lines (S) may be formed inside the pixel region (A) in addition to the second electrodes 31. The scan lines (S) formed in the pixel region (A) are electrically coupled with scan lines (S) formed in a wiring region (B) outside the pixel region (A), as described below.

Meanwhile, scan lines which are electrically coupled with the scan lines inside the pixel region (A) are formed in the wiring regions (B) of both sides of the pixel region (A). Such scan lines of the wiring region (B) may be formed using electrode materials inside the pixel region (A). For example, the scan lines of the wiring region (B) may be formed of the same ITO film 37 as the first electrode 31 and the data lines (D) in the process for forming the first electrode 31 and the data lines.

Meanwhile, although not shown in FIG. 2, the data lines (D) between the pixel unit 20 and the drive circuit unit 40 may be formed so that the first electrode 31 having a striped shape extends into a region of the drive circuit unit 40.

In the above-mentioned organic light emitting display device, a luminance of the pixels is sensitive to a voltage level of the scan signal and/or the data signal. Therefore, if the scan lines and the data lines are formed of ITO, a conductive layer 38 having a relatively lower resistance than ITO is further formed on the ITO film 37 of the scan lines (S) and the data lines (D) formed outside the pixel unit 20, that is, between the pixel unit 20 and the drive circuit unit 40, resulting in a reduction in resistance of the scan lines (S) and the data lines (D). That is to say, one region of the scan lines (S) and the data lines (D) arranged inside the pixel unit 20 is formed of the first conductive layer 37 comprises the same the materials as the first electrode 31 and/or the second electrode 32 of the organic light emitting diode, and the other region of the scan lines (S) and the data lines (D) arranged between the pixel unit 20 and the drive circuit unit 40 comprises a laminated structure of the first conductive layer 37 and the second conductive layer 38 comprising materials having a lower resistance than the first conductive layer 37. Such a second conductive layer 38 may be formed in a single-layer structure using materials such as chromium (Cr), aluminum (Al), and the like, or formed in a laminated structure using at least two materials having different resistances.

FIG. 3 is a cross-sectional view showing one embodiment of a scan line and/or data line as shown in FIG. 1 and FIG. 2. The scan line and/or data line shown FIG. 3 is disposed between the pixel unit and the drive circuit unit. Referring to FIG. 3, the scan line (S) and/or the data line (D) connecting the drive circuit unit 40 with the pixel unit 20 is formed in a laminated structure of a first conductive layer 37 comprising the same ITO material as the first electrode of the organic light emitting diode (OLED); and a second conductive layer 38 formed in a triple-layer structure of molybdenum (Mo)-aluminum (Al)-molybdenum (Mo). If the second conductive layer 38 comprises the molybdenum (Mo)-aluminum (Al)-molybdenum (Mo) structure described above, the resistance of the scan lines (S) and/or the data lines (D) may be lowered more effectively than if the second conductive layer 38 is formed of a single layer of a material such as chromium (Cr) and the like.

The above-described organic light emitting display device as shown in FIG. 1 to FIG. 3 is put on the market only if the products pass inspection procedures such as aging and current leakage inspection, and the like. In such an inspection procedure, the organic light emitting display device may be inspected on the mother substrate before scribing or dicing, or inspected as a finished product scribing or dicing the mother substrate. However, if the organic light emitting display devices are separately inspected as the finished products, the inspection efficiency may be lowered compared with inspecting a plurality of the organic light emitting display devices on the mother substrate. Accordingly, it is preferred to inspect a plurality of the organic light emitting display devices on the mother substrate at the same time.

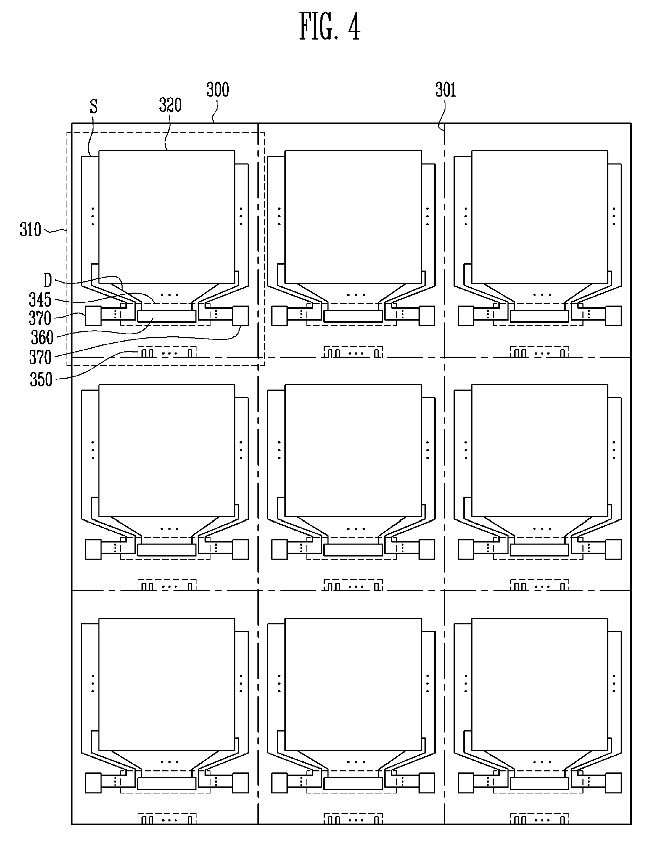

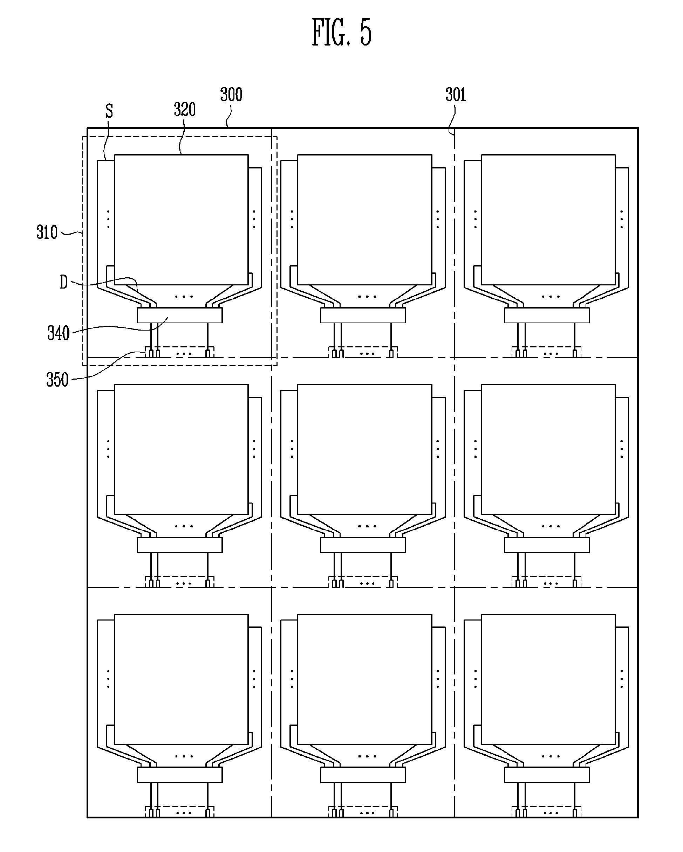

FIG. 4 and FIG. 5 are top views showing a mother substrate 300 of an organic light emitting display device. Here, FIG. 4 shows a mother substrate in the inspection procedure before the installation of the drive circuit unit, and FIG. 5 shows a mother substrate in which the drive circuit unit is installed after the inspection is completed. Referring to FIG. 4 and FIG. 5, the mother substrate 300 of the organic light emitting display devices according to one preferred embodiment includes a plurality of organic light emitting display devices 310 arranged in a matrix defined by the scribing line 301.

In each of the organic light emitting display devices 310 in the inspection procedure, the pixel unit 320 is electrically coupled with the first pin-contact unit 360 and the second pin-contact unit 370 through the scan lines (S) and the data lines (D).

More particularly, the first and second pin-contact units 360, 370 are formed between the pixel unit 320 and the pad unit 350, which are arranged inside the organic light emitting display devices 310.

Here, the first pin-contact unit 360 is formed in a drive circuit installation region 345 in a short bar form where one side end of the data lines (D) is coupled with each other using suitable low resistance materials, such as aluminum (Al).

Further, the second pin-contact unit 370 is formed in a short bar form. Ends of the scan lines (S) extending toward the drive circuit installation region 345 are further extended toward each side of the drive circuit installation region 345 using materials such as aluminum (Al), so the scan lines (S) can be coupled with the second pin-contact unit 370 in a short bar form. In the embodiment shown in FIG. 4 and FIG. 5 the odd-numbered scan lines and even-numbered scan lines (S) extend respectively toward each side of the pixel unit 320, and are coupled to two second pin-contact units 370 formed on each side of the drive circuit installation region 345, respectively, but other possible embodiments are not particularly limited thereto.

Such first and second pin-contact units 360, 370 receive an inspection_data signal and an inspection_scan signal during the inspection procedure, respectively. That is to say, the mother substrate 300 is positioned inside an inspection apparatus during various inspections such as aging or lighting inspections, and the like, where an inspection is performed on a plurality of the organic light emitting display devices 310 formed on the mother substrate 300 by receiving an inspection signal through the first and second pin-contact units 360, 370 in a pin contact manner. Such first and second pin-contact units 360, 370 are removed after the inspection is completed. That is to say, after the inspection is completed, a process for peeling off the first and second pin-contact units 360, 370 is carried out.

Then, a drive circuit unit 340 is installed in the drive circuit installation region 345, as shown in FIG. 5, and the organic light emitting display devices 310 are separated from the mother substrate 300 along the scribing line 301 one-by-one.

According to the above-mentioned organic light emitting display device, mother substrate 300 as shown in FIG. 4 and FIG. 5, the inspection efficiency may be improved since the inspection on a plurality of the organic light emitting display devices 310 may be carried out on the mother substrate 300 at the same time.

However, the manufacturing process may be rather complicated since the process for removing first and second pin-contact units 360, 370 should be carried out after the inspection is completed. In order to effectively peel off the first and second pin-contact units 360, 370 without any damage to the data lines (D) and the scan lines (S), the first and second pin-contact units 360, 370 should also be formed of different materials than the conductive layer materials constituting the data lines (D) and the scan lines (S).

That is to say, this embodiment in which the first and second pin-contact units 360, 370 are formed by extending the ends of the data lines (D) and the scan lines (S), by using aluminum (Al), to couple them to each other may be applied if the second conductive layer 38 of the data lines (D) and the scan lines (S) is formed of materials such as chromium (Cr), but may not be applied where the structure of the second conductive layer 38 comprises a molybdenum (Mo)-aluminum (Al)-molybdenum (Mo) structure having a low resistance as shown in FIG. 3.

Accordingly, it is desirable to propose an organic light emitting display device where may be applied the structure of the second conductive layer 38 of molybdenum (Mo)-aluminum (Al)-molybdenum (Mo) having a low resistance, and a corresponding mother substrate, but where the peeling process of the first and second pin-contact units 360, 370 is omitted.

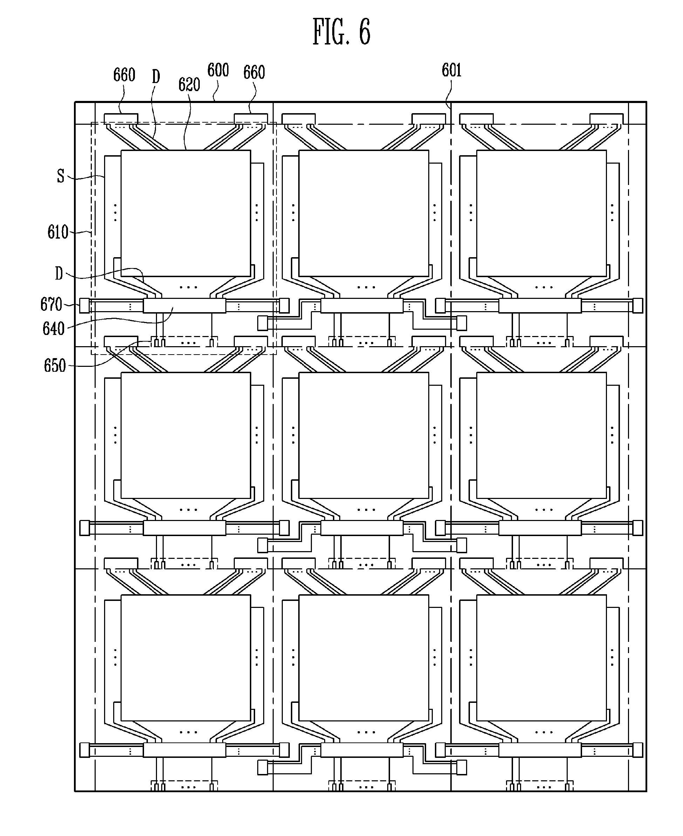

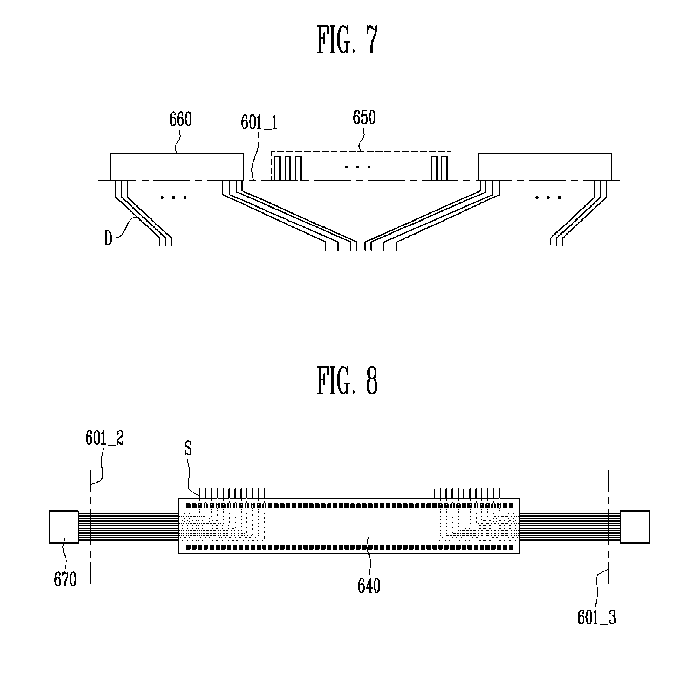

FIG. 6 is a top view showing a mother substrate of an organic light emitting display device according to a preferred embodiment of the invention. And, FIG. 7 is a detail view showing data lines and a first pin-contact unit as shown in FIG. 6, and FIG. 8 is a detail view showing scan lines and a second pin-contact unit as shown in FIG. 6. Referring to FIG. 6 to FIG. 8, the mother substrate 600 of the organic light emitting display device according to another preferred embodiment includes a plurality of organic light emitting display devices 610 including data lines (D) and scan lines (S); and scribing lines 601 arranged each between the organic light emitting display devices 610 in a row direction or a column direction, which define each region of the organic light emitting display devices 610. That is to say, each of the organic light emitting display devices 610 is arranged on the mother substrate 600 in a matrix, and its region is defined by four scribing lines 601 arranged up and down and right and left. For example, a region of one organic light emitting display device 610 may be defined by an upper first scribing line; right/left second and third scribing lines arranged orthogonally to the first scribing line and arranged in parallel with each other; and a lower fourth scribing line arranged orthogonally to the second and third scribing lines and arranged in parallel with the first scribing line.

Here, the data lines (D) formed in each of the organic light emitting display devices 610 extend from an upper side of the pixel unit 620, and are electrically coupled with a first pin-contact unit 660 formed outside the scribing line 601 defining the top of the region of the organic light emitting display device 610. That is to say, one end of each data line (D) is extended to the first scribing line 601_1, and their terminals are electrically coupled with the first pin-contact unit 660 formed outside the first scribing line 601_1 (relatively to the display device 610 partly defined by this scribing line 601_1), as shown in FIG. 7.

For example, the data lines (D) may be electrically coupled to one of two first contact units 660 formed in a lower dummy region of an adjacent organic light emitting display device 610 in an adjacent row of display devices sharing the first scribing line 601_1, for example, in a dummy region at both sides of the pad unit 650.

Meanwhile, the scan lines (S) formed in each of the organic light emitting display devices 610 extend outward to the right and/or left scribing lines 601 and are electrically coupled with the second pin-contact unit 670 formed outside the scribing line 601. That is to say, an end of each scan line (S) is redirected right or left towards the second or third scribing line 601_2, 601_3 in a region where the scan lines (S) overlap the drive circuit unit 640, as shown in FIG. 8. Therefore, end of each scan line (S) is electrically coupled with the second pin-contact unit 670 formed outside the second and/or third scribing line 601_2, 601_3 by extending an end of each scan line (S) to the outside of the second and/or third scribing line 601_2, 601_3, as shown in FIG. 8.

For example, the scan lines (S) may be electrically coupled to the second pin-contact unit 670 formed in a right and/or left dummy region of adjacent organic light emitting display devices in adjacent columns sharing the second and/or third scribing lines 601_2, 601_3, for example in dummy regions at both sides of the drive circuit unit 640 of the adjacent organic light emitting display devices.

Such first and second pin-contact units 660, 670 may comprise an aluminum (Al) short bar, and receive an inspection_data signal and an inspection_scan signal, respectively, when the inspection on the organic light emitting display devices 610 is carried out on the mother substrate 600. Accordingly, the inspection_data signal and the inspection_scan signal are supplied respectively to the data lines (D) and the scan lines (S) of the organic light emitting display device 610 arranged in adjacent rows or columns when their inspection is carried out. However, the inspection of the organic light emitting display device 610 is preferably carried out before the drive circuit unit 640 is installed in the organic light emitting display device 610.

The first and second pin-contact units 660, 670 are electrically isolated from other components, particularly the data lines (D) and the scan lines (S) of the organic light emitting display device 610 within the region defined by the scribing lines 601 in which the first and second pin-contact units 660, 670 are disposed. After the scribing the organic light emitting display device 610, since the first and second pin-contact units 660, 670 are arranged outside the scribing line 601 of the organic light emitting display device 610 coupled to the first and second pin-contact units 660, 670, the first and second pin-contact units 660, 670 do not have an effect on the driving of the organic light emitting display device 610.

According to the above-mentioned mother substrate 600 of the organic light emitting display device as shown in FIG. 6 to FIG. 8, the inspection efficiency may be improved since the inspection on a plurality of the organic light emitting display devices 610 may be carried out on the mother substrate 600 at the same time.

Also, some embodiments are used with a chip-on-glass (COG)-type organic light emitting display device by suitably arranging the first and second pin-contact unit 660, 670 outside the scribing line 601, and the connection with the data lines (D) and the scan lines (S) may be broken in the scribing process without performing a peeling process for removing the first and second pin-contact units 660, 670. Therefore, the manufacturing process is simplified.

Also, because it is unnecessary to remove the first and second pin-contact units 660, 670, the materials used in the second conductive layer 38 may be easily selected, wherein the second conductive layer 38 is used for forming data lines (D) and scan lines (S) extended outward from the pixel unit 620. Accordingly, its design may be easily made herein, and the resistance of the data lines (D) and the scan lines (S) may be also reduced by employing the second conductive layer 38 of molybdenum (Mo)-aluminum (Al)-molybdenum (Mo) having a low resistance, as shown in FIG. 3.

For example, the data lines (D) arranged inside the pixel unit 620 are formed of the first conductive layer 37 which comprises the same ITO film as the first electrode of the organic light emitting diode (OLED), and the data lines (D) formed outside the pixel unit 620, that is, formed between the pixel unit 620 and the drive circuit unit 640 may be formed of a first conductive layer 37 and a second conductive layer 38 comprising a laminated structure of molybdenum (Mo)-aluminum (Al)-molybdenum (Mo) having a lower resistance than the first conductive layer 37. And, the scan lines (S) arranged inside the pixel unit 620 are formed of aluminum (Al) in the same manner as the second electrode of the organic light emitting diode (OLED), and the scan lines (S) formed outside the pixel unit 620, that is, formed between the pixel unit 620 and the drive circuit unit 640 are formed so that the second conductive layer 38 can be coupled with the first conductive layer 37 comprising an ITO film, wherein the second conductive layer 38 comprises a laminated structure of molybdenum (Mo)-aluminum (Al)-molybdenum (Mo). Therefore, the scan lines (S) may be formed so that they can be electrically coupled with the scan lines (S) arranged inside the pixel unit 620. That is to say, the first and/or second pin-contact units 660, 670 and the second conductive layer 68 may all comprise aluminum (Al).

Although, the above-described embodiment shows the organic light emitting display device 610 used for the bottom light emission, the possible embodiments are not particularly limited thereto. For example, the materials forming the data lines (D) and the scan lines (S) arranged inside the pixel unit 620 may be reversed if the organic light emitting display device 610 is used for top light emission, and the data lines (D) and the scan lines (S) arranged inside the pixel unit 620 may be all formed of ITO film if the organic light emitting display device 610 is used for dual light emission.

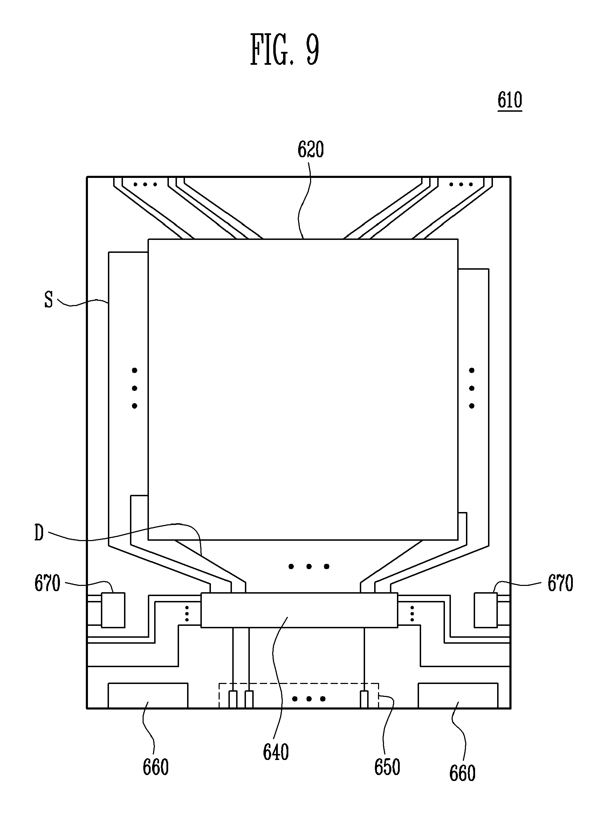

FIG. 9 is a plane view showing one embodiment of the organic light emitting display device 610 scribed along the scribing lines shown in FIG. 6. Referring to FIG. 9, the organic light emitting display device 610, which is scribed from the mother substrate 600 along the scribing line 601 shown in FIG. 6, includes a pixel unit 620, a drive circuit unit 640, a pad unit 650, and first and second pin-contact units 660, 670.

The pixel unit 620 includes a plurality of pixels arranged at crossing points of the scan lines (S) and the data lines (D), and including at least an organic light emitting diode. The drive circuit unit 640 is arranged on one side of the pixel unit 620, and then electrically coupled with the pixel unit 620. The pad unit 650 is electrically coupled to the drive circuit unit 640 to supply a power source voltage and/or a control signal to the drive circuit unit 640.

The first and second pin-contact units 660, 670 are arranged in a lower region (which can be called a "dummy region" as it has no specific function for the concerned device) below the pixel unit 620, and electrically isolated from other components, particularly the data lines (D) and the scan lines (S). More particularly, the first pin-contact unit 660 is formed in dummy regions at both sides of the pad unit 650, and the second pin-contact unit 670 may be formed in a dummy region on at least one side, for example, on both sides, of the drive circuit unit 640.

Meanwhile, the data lines (D) extend toward the upper dummy region of the pixel unit 620, and their extended terminals are floated *(i.e.* are free from further connection), and the scan lines (S) extend toward edges of both sides of a lower dummy region of the pixel unit 620 and their extended terminals are floated. A protective layer (not shown) such as Tuffy may be disposed over the data lines (D) and the scan lines (S) to protect the floated data lines (D) and scan lines (S).

Suitable materials for the data lines (D) and the scan lines (S), and the first and second pin-contact units 660, 670 are identical to the materials as described in FIG. 6 to FIG. 8, and therefore their detailed description is omitted.

As described above, the organic light emitting display and the mother substrate thereof may be useful to improve the inspection efficiency and simplify the manufacturing process. Also, the organic light emitting display may be easily designed due to the wide selection in the component of the second conductive layer constituting the data lines and the scan lines. Also, the resistance of the data lines and the scan lines may be reduced since the organic light emitting display according to the present invention is applicable to the structure of the second conductive layer of molybdenum (Mo)-aluminum (Al)-molybdenum (Mo) having a low resistance.

Although exemplary embodiments have been shown and described, they are only possible ways of implementing the invention, which is not limited thereto.

## Claims

1. A mother substrate (600) of an organic light emitting display device comprising:
a plurality of organic light emitting display devices (610) comprising data lines (D) and scan lines (S) disposed on a substrate; and
scribing lines (601) arranged horizontally and vertically between adjacent organic light emitting display devices (610), the scribing lines (601) partitioning the substrate (600) into rows and columns of regions, each region comprising an organic light emitting display device (610),
wherein the data lines (D) of an organic light emitting display device (610) formed inside a region defined by first, second, third, and fourth scribing lines extend out of the region and are electrically coupled with a first pin-contact unit (660) formed outside the first scribing line (601_1), and
wherein the scan lines (S) of the organic light emitting display device (610) formed inside the region defined by the first, second, third, and fourth scribing lines extend out of the region and are electrically coupled with a second pin-contact unit (670) formed outside the second (601_2) or third (601_3) scribing line, which are orthogonal to the first scribing line (601_1) and parallel with each other.

2. The mother substrate of the organic light emitting display device according to claim 1,
wherein the first pin-contact unit (660) is formed in a lower region of an adjacent organic light emitting display device in an adjacent row sharing the first (601_1) scribing line, and
wherein the second pin-contact unit (670) is formed in a left or right region of an adjacent organic light emitting display device in an adjacent column sharing the second or third scribing line (601_2; 601_3).

3. The mother substrate of the organic light emitting display device according to claim 2, wherein the first and second pin-contact units (660, 670) are electrically isolated from the data lines and the scan lines of the adjacent organic light emitting display devices in which the first and second pin-contact units (660, 670) are disposed.

4. The mother substrate of the organic light emitting display device according to any of claims 1-3, wherein each of the organic light emitting display devices comprises:
a pixel unit (620) comprising a plurality of pixels arranged at crossing points of the data lines (D) and the scan lines (S), each pixel comprising at least an organic light emitting diode;
a drive circuit unit (640) electrically coupled to the data lines (D) and scan lines (S) configured to supply a driving signal to the pixel unit (620); and
a pad unit (650) electrically coupled to the drive circuit unit (640) configured to supply at least one of a power source voltage and a control signal to the drive circuit unit (640).

5. The mother substrate of the organic light emitting display device according to claim 4,
wherein one of a scan line and a data line disposed inside the pixel unit (620) comprises a first conductive layer (37) comprising the same material as a first electrode or a second electrode of the organic light emitting diode, and
wherein the other of said scan line and said data line disposed between the pixel unit (620) and the drive circuit unit (640) comprises a laminated structure comprising the first conductive layer (37) and a second conductive layer (38) comprising a different material than the first conductive layer (37).

6. The mother substrate of the organic light emitting display device according to claim 5, wherein the second conductive layer (38) comprises a material having a lower resistance than the first conductive layer (37).

7. The mother substrate of the organic light emitting display device according to claim 5, wherein the second conductive layer (38) comprises one of molybdenum (Mo) and aluminum (Al).

8. The mother substrate of the organic light emitting display device according to claim 5, wherein the second conductive layer (38) comprises a triple-layer structure of molybdenum (Mo)-aluminum (Al)-molybdenum (Mo).

9. The mother substrate of the organic light emitting display device according to claim 5, wherein the first or second pin-contact unit (660; 670) comprises a material of the second conductive layer (38).

10. The mother substrate of the organic light emitting display device according to claim 9, wherein the second conductive layer (38) comprises at least aluminum (Al), and the first or second pin-contact unit (660; 670) comprises aluminum (Al).

11. The mother substrate of the organic light emitting display device according to claim 5, wherein the first conductive layer (37) comprises at least an indium tin oxide (ITO) film.

12. The mother substrate of the organic light emitting display device according to any of claims 4-11, wherein the first pin-contact unit (660) is formed in regions on either side of a pad unit of an adjacent organic light emitting display device in an adjacent row sharing the first scribing line (601_1).

13. The mother substrate of the organic light emitting display device according to any of claims 4-12, wherein the second pin-contact unit (670) is formed in at least one of a region of a drive circuit unit installed in an adjacent organic light emitting display device in an adjacent column sharing the second scribing line (601_2) and a region of a drive circuit unit installed in an adjacent organic light emitting display device sharing the third scribing line (601_3).

14. The mother substrate of the organic light emitting display device according to any of claims 4-13, wherein the drive circuit unit (640) is installed in a form of an integrated circuit chip.

15. The mother substrate of the organic light emitting display device according to claim 1, wherein the first and second pin-contact units (660; 670) are configured to receive an inspection_data signal and an inspection_scan signal, respectively.

16. An organic light emitting display device, comprising:
a pixel unit (620) comprising a plurality of pixels arranged at crossing points of scan lines (S) and data lines (D), each pixel comprising at least an organic light emitting diode; and
first and second pin-contact units (660; 670) disposed in a lower region of the pixel unit and electrically isolated from the scan lines (S) and the data lines (D),
wherein the data lines (D) extend toward an upper region of the pixel unit (620) and the extended terminals are floated, and the scan lines (S) extend toward edges of both sides of a lower region of the pixel unit (620) and the extended terminals are floated.

17. The organic light emitting display device according to claim 16, further comprising;
a drive circuit unit (640) disposed on one side of the pixel unit (620) and electrically coupled with the pixel unit (620); and
a pad unit (650) electrically coupled to the drive circuit unit (640) configured to supply at least one of a power source voltage and a control signal to the drive circuit unit (640).

18. The organic light emitting display device according to claim 17, wherein the first pin-contact unit (660) is formed in regions on both sides of the pad unit (650).

19. The organic light emitting display device according to claim 17 or 18, wherein the second pin-contact unit (670) is formed in a region on at least one side of the drive circuit unit (640).

20. The organic light emitting display device according to claim 19, wherein the second pin-contact unit (670) is formed in regions on both sides of the drive circuit unit (640).

21. The organic light emitting display device according to claim 16,
wherein one of a scan line and a data line arranged inside the pixel unit (620) comprises a first conductive layer (37) comprising the same material as the first electrode or the second electrode of the organic light emitting diode, and
wherein the other of the scan line and data line extending outwardly to the pixel unit (620) comprises a laminated structure comprising the first conductive layer (37) and a second conductive layer (38) comprising a different material than the first conductive layer.

22. The organic light emitting display device according to claim 21, wherein the first or second pin-contact unit (660; 670) comprises at least one material of the second conductive layer (38).

23. The organic light emitting display device according to claim 22, wherein the first or second pin-contact unit (660; 670) and the second conductive layer (38) comprises at least aluminum (Al).

24. The organic light emitting display device according to claim 21, wherein the second conductive layer (38) comprises a material having a lower resistance than the first conductive layer (37).

25. The organic light emitting display device according to claim 21, wherein the second conductive layer (38) comprises a laminated structure of molybdenum (Mo)-aluminum (Al)-molybdenum (Mo).

26. The organic light emitting display device according to claim 21, wherein the first conductive layer (37) comprises at least an indium tin oxide (ITO) film.
